# EUROPÄISCHE PATENTSCHRIFT

(11) **EP 0 950 860 B1**
(45) Veröffentlichungstag und Bekanntmachung des Hinweises auf die Patenterteilung: **08.12.2004**
(21) Anmeldenummer: 99107755.3
(22) Anmeldetag: 19.04.1999
(51) Int. Cl.: F24C 7/08, H05B 3/74

(54) **Kochfeld mit Bedienbereich**
Cooking hob with an operating zone
Plaque de cuisson avec une zone de commande

(30) Priorität: 17.04.1998 DE 19817195
(43) Veröffentlichungstag der Anmeldung: 20.10.1999
(73) Patentinhaber: BSH Bosch und Siemens Hausgeräte GmbH, 81739 München (DE)
(72) Erfinder: Theine, Markus Dipl.-Ing., 83395 Freilassing (DE)

(56) Entgegenhaltungen:
- DE-A- 3 242 010
- DE-A- 19 610 073
- US-A- 3 838 505

## Beschreibung

Die vorliegende Erfindung betrifft eine Anordnung mit einem Kochfeld in einer Kochfeldaufnahme einer Arbeitsplatte mit einer Kochplatte aus Glaskeramik oder ähnlichem mit Berührungsflächen eines Bedienbereiches auf der Oberseite der Kochplatte, die durch unterhalb der Kochplatte angeordnete Sensoren einer Bedieneinheit überwacht sind, die in Verbindung steht mit einer Steuereinheit zum Steuern von unterhalb der Kochplatte angeordneten Heizelementen.

Eine derartige Anordnung ist bekannt aus der Druckschrift DE 196 10 073 A1, wobei unterhalb der Glaskeramikplatte Strahlungsheizquellen sowie Bedien- und Anzeigeelemente integriert sind. Die Glaskeramikplatte ist von einem Kochfeldrahmen umzogen, der in den entsprechend gestalteten Ausschnitt der Arbeitsplatte eingesetzt und gehaltert ist. Nachteilig am bekannten Stand der Technik ist, dass aufgrund der begrenzten und üblicherweise standardisierten Ausschnittgröße in der Arbeitsplatte bei den typischerweise in einem Glaskeramikkochfeld vorhandenen vier Kochstellen der geometrische Abstand zwischen den beheizten Zonen und den Berührungsflächen des Bedienbereiches relativ gering ist. Dies führt aufgrund der Wärmequerleitung in der Glaskeramik zu für die Bedienperson unangenehmen Berührungstemperaturen der Oberseite der Kochplatte im Bereich der Berührungsflächen.

Bekannt ist weiter aus der DE 32 42 010 A1 eine Kochmulde, die in einem Ausschnitt einer Arbeitsplatte einsetzbar ist, mit einer Kochstellen aufweisenden Muldenplatte, die von einem Rahmen umzogen ist. Der Rahmen weist wenigstens einen verbreiterten, vorzugsweise in der Muldenplatten-Ebene liegenden Rahmenschenkel auf, der als Kupplungsbasis für darauf aufsetzbare und/oder darin einsetzbare Zusatzteile wie Bedientableau, Aufsetzkasten oder dergleichen dient.

Weiter ist aus der Druckschrift US 3,838,505 ein Kochfeld bekannt, dessen Kochbereich durch eine Trennleiste vom Bedien- und Anzeigebereich getrennt ist. Die derart aufgebaute Kochmulde ist in den Arbeitsplattenausschnitt eingebaut.

Aufgabe der vorliegenden Erfindung ist es, eine Anordnung nach dem Oberbegriff des Patentanspruches 1 derart zu verbessern, dass die Temperatur der Berührungsflächen des Kochfeldes reduziert ist.

Erfindungsgemäß ist dies dadurch erreicht, dass die Kochplatte die Arbeitsplatte bei in die Kochfeldaufnahme eingebautem Kochfeld mit seinem Bedienbereich überdeckt, so dass dieser im wesentlichen außerhalb der Kochfeldaufnahme angeordnet ist. Durch die Vergrößerung der Kochplattenfläche bei gleichbleibender Größe des Arbeitsplattenausschnittes ist es auf einfache Weise möglich, den Abstand der Berührungsflächen von den Heizelementen zu vergrößern. Da die Vergrößerung des Abstandes um 1 mm die Temperatur der Berührungsfläche um etwa 1 K reduziert, ist dadurch mit einfachen Mitteln eine deutliche Herabsetzung der Berührungsflächentemperatur möglich. Besonders günstig ist es, wenn die Berührungsflächen außerhalb eines wannenförmigen Gehäuses zur Aufnahme der Heizkörper und weiterer Funktionskomponenten des Kochfeldes angeordnet sind. Erfindungsgemäß kann stets ein geeigneter Abstand des Bedienbereiches vom Rand der Kochplatte eingehalten werden.

Vorteilhafterweise sind die Sensoren in dem Spalt zwischen der Kochplatte und der Arbeitsplatte angeordnet. Dies ist zum einen ein kühler Bereich der Anordnung und zum anderen wird das durch die Anordnung vorgegebene Raumangebot optimal genutzt.

Gemäß einer bevorzugten Ausführungsform ist der Sensor durch eine Metallelektrode gebildet, die an der Unterseite der Kochplatte im Bedienbereich aufgebracht ist. Die dünne Metallelektrode kann durch das Aufkleben einer geeigneten Folie oder durch eine geeignete Beschichtungs- bzw. Bedruckungstechnik an der Unterseite der Kochplatte aufgebracht sein. Der kapazitive Abgriff durch eine oder mehrere Elektroden ist dabei aufgrund des flachen Aufbaues und der sicheren Meßtechnik besonders geeignet. Alternativ könnte zum induktiven Abgriff auch eine spiralförmige Flachspule an der Unterseite der Kochplatte vorgesehen sein. Ebenfalls wäre es möglich, im Bereich unterhalb der Berührungsflächen geeignete Reflektoren vorzusehen, die im wesentlichen waagrecht unterhalb der Kochplatte von einer geeigneten Infrarotsensorik ausgesendete Infrarotstrahlung im wesentlichen senkrecht nach oben reflektieren und die durch einen gegebenenfalls vorhandenen Betätigungsfinger einer Bedienperson reflektierte Strahlung wieder zu einem Infrarotempfänger der Bedienelektronik zurücksenden.

Zur Vereinfachung der Bedienung des Kochfeldes ist der Bedienbereich und damit der Anzeigebereich in dem einer Bedienperson zugewandten Endabschnitt der Kochplatte vorgesehen.
Insbesondere in diesem Bereich überlappt die Kochplatte die Arbeitsplatte vorteilhafterweise etwa um 10 bis 40 mm, insbesondere um etwa 15 bis 35 mm. In einem derartigen Überlappungsbereich ist einerseits problemlos eine geeignet dimensionierte Berührungsfläche des Bedienbereiches realisierbar. Andererseits ist die Tiefe des einer Bedienperson zugewandten Arbeitsplattensteges typischerweise auf etwa 50 mm begrenzt. Abhängig von den jeweiligen besonderen Gegebenheiten kann der Bedienbereich der Kochplatte alternativ auch an einem der Seitenbereiche der Kochplatte vorgesehen sein.

Vorteilhafterweise ist die Kochplatte mit Hilfe eines geeigneten Abstandshalters von der Oberseite der Arbeitsplatte beabstandet. Dies gewährleistet zum einen eine feste und dichte Halterung des Kochfeldes in der Arbeitsplatte und schafft zum anderen einen Raum zur Unterbringung der Sensoren.

Nachfolgend ist anhand schematischer Darstellungen ein Ausführungsbeispiel des findungsgemäßen Kochfeldes beschrieben.

Es zeigen:
- Fig. 1: in einer Seitenansicht teilweise in einer Schnittdarstellung abschnittsweise das in die Arbeitsplatte eingebaute Kochfeld und
- Fig. 2: in verkleinertem Maßstab in einer Draufsicht das eingebaute Kochfeld.

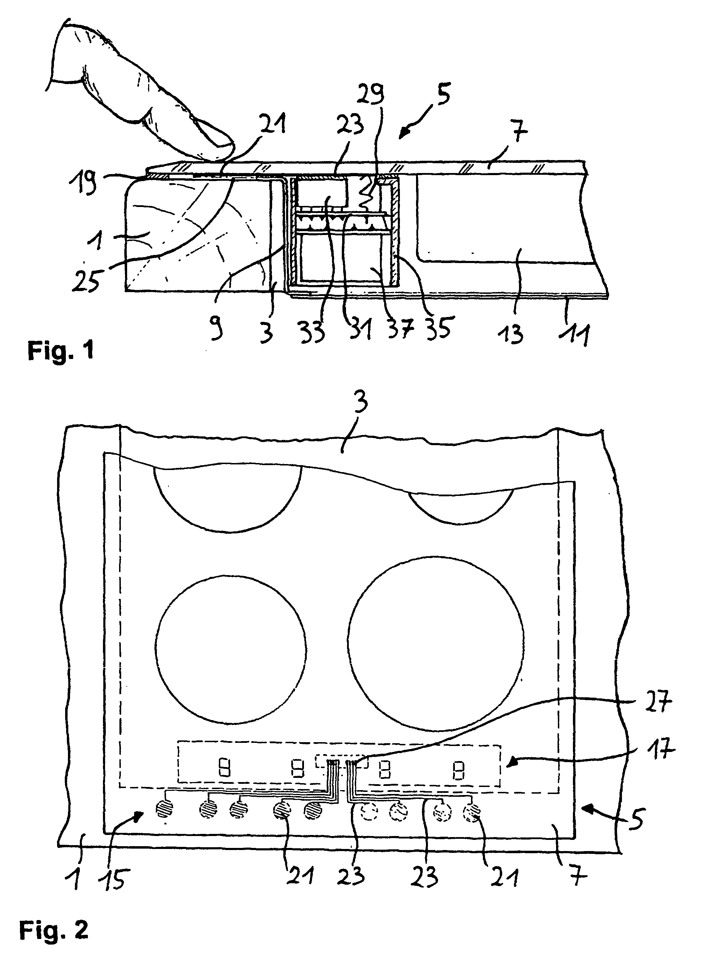

Figur 1 zeigt den einer Bedienperson zugewandten Frontbereich einer Arbeitsplatte 1 mit einem rechteckigen Ausschnitt 3 zum Einbau eines Touch-Control-Kochfeldes 5. Das Kochfeld 5 weist eine Kochplatte 7 aus Glaskeramik auf, an deren Unterseite ein metallischer Rahmen 9 im wesentlichen umfangsseitig dicht befestigt ist. Durch eine Bodenplatte 11 wird der Rahmen 9 zu einem wannenförmigen Gehäuse des Kochfeldes 5 ergänzt, in dem dessen Funktionskomponenten angeordnet sind. An der Unterseite der Kochplatte 7 sind im Bereich der vier markierten Kochstellen topfförmige Heizkörper 13 gehaltert. Mit dem Rahmen 9 ist das Kochfeld 5 in den Ausschnitt 3 eingesetzt. Dabei liegt ein oberer rechtwinkelig abstehender Endabschnitt des Rahmens 9 an der Oberseite der Arbeitsplatte 1 umfangsseitig auf. Die Kochplatte 7 erstreckt sich über den Ausschnitt 3 hinaus oberhalb der Arbeitsplatte 1 in deren frontseitigen Endabschnitt und endet kurz vor der frontseitigen Kante der Arbeitsplatte 1 mit einer kurzen Facette. Dabei überdeckt die Kochplatte 7 die Arbeitsplatte 1 um etwa 35 mm. In diesem Überlappungsbereich ist ein Bedienbereich 15 des Kochfeldes 5 vorgesehen. Beabstandet davon ist zwischen den beiden frontseitig angeordneten Kochstellen und dem Bedienbereich 15 ein Anzeigebereich 17 des Kochfeldes 5 angeordnet. Die Kochplatte 7 liegt umfangsseitig zusätzlich auf einem rahmenartigen elastischen und dichtenden Abstandselement 19 auf.

Im Bedienbereich 15 sind an der Unterseite der Kochplatte 7 mehrere dünne kreisförmige Elektroden 21 einer kapazitiven Touch-Control-Sensoranordnung aufgedruckt. Durch das Setzen eines Fingers der Bedienperson auf die Elektrode 21 wird die Kapazität der Sensoranordnung verändert und als Bedienwunsch erkannt. Von den Elektroden 21 führen zwischen der Unterseite der Kochplatte 7 und dem im wesentlichen dicht anliegenden Rahmen 9 jeweils schmale parallel geführte dünne Sensorleitungen 23 in den innerhalb des Kochfeldgehäuses angeordneten Anzeigebereich 17 der Kochplatte 7. Dabei ist die Geometrie der Sensorleitungen 23 derart gestaltet, daß eine Berührung mit einem Finger der Bedienperson in diesem Bereich zu keiner Fehlbedienung des Kochfeldes 5 führen kann. Zum Schutz und zur elektrischen Isolation der Elektrode 21 und der Sensorleitungen 23 sind diese mit einer geeigneten Isolationsschicht 25 überzogen. Im Anzeigebereich 17 enden die Sensorleitungen 23 in entsprechenden Kontaktpads 27. Über Federelemente 29 sind die Kontaktpads 27 und damit die Elektroden 21 der kapazitiven Sensoranordnung mit einer Elektronikleiterplatte 31 elektrisch leitend verbunden. Auf dieser Leiterplatte 31 sind unter anderem an sich bekannte Anzeigeelemente 33 z.B. in Form von Siebensegmentanzeigen angeordnet. Diese Anzeige- und Bedienelemente 27, 29, 31 sind in einem an der Unterseite der Kochplatte 7 gehalterten Gehäuse 35 zusammen mit Schaltelementen 37 zur Steuerung der Heizleistung der Heizkörper 13 vorgesehen.

## Patentansprüche

1. Anordnung mit einem Kochfeld in einer Kochfeldaufnahme einer Arbeitsplatte mit einer Kochplatte aus Glaskeramik oder ähnlichem mit Berührungsflächen eines Bedienbereiches auf der Oberseite der Kochplatte, die durch unterhalb der Kochplatte angeordnete Sensoren einer Bedieneinheit des Kochfeldes überwacht sind, die in Verbindung steht mit einer Steuereinheit des Kochfeldes zum Steuern von unterhalb der Kochplatte angeordneten Heizelementen, **dadurch gekennzeichnet, dass** die Kochplatte (7) die Arbeitsplatte (1) bei in die Kochfeldaufnahme (3) eingebautem Kochfeld (5) mit seinem Bedienbereich (15) überdeckt, so dass dieser im wesentlichen außerhalb der Kochfeldaufnahme (3) angeordnet ist.

2. Anordnung nach Anspruch 1, **dadurch gekennzeichnet, dass** die Sensoren (21) zwischen der Kochplatte (7) und der Arbeitsplatte (1) angeordnet sind.

3. Anordnung nach einem der vorhergehenden Ansprüche, **dadurch gekennzeichnet, dass** die Kochplatte (7) die Arbeitsplatte (1) etwa um 10 bis 40 mm, insbesondere um etwa 15 bis 35 mm überlappt.

4. Anordnung nach einem der vorhergehenden Ansprüche, **dadurch gekennzeichnet, dass** der Bedienbereich (15) in dem einer Bedienperson zugewandten frontseitigen Endabschnitt der Kochplatte (7) vorgesehen ist.

5. Anordnung nach einem der vorhergehenden Ansprüche, **dadurch gekennzeichnet, dass** die Kochplatte (7) mit Hilfe eines Abstandshalters (19) von der Oberseite der Arbeitsplatte (1) beabstandet ist.

## Claims

1. Arrangement with a cooking field in a cooking field mount of a work plate with a cooking plate of glass-ceramic or similar with contact surfaces of an operating region on the upper side of the cooking plate, which are monitored by sensors, which are arranged below the cooking plate, of an operating unit of the cooking field, which is disposed in connection with a control unit of the cooking field for controlling the heating elements arranged below the cooking plate, **characterised in that** the cooking plate (7) covers, by its operating region (15), the work plate (1) when the cooking field (5) is installed in the cooking field mount (3), so that this region is arranged substantially outside the cooking field mount (3).

2. Arrangement according to claim 1, **characterised in that** the sensors (21) are arranged between the cooking plate (7) and the work plate (1).

3. Arrangement according to one of the preceding claims, **characterised in that** the cooking plate (7) overlaps the work plate (1) by approximately 10 to 40 millimetres, particularly by approximately 15 to 35 millimetres.

4. Arrangement according to one of the preceding claims, **characterised in that** the operating region (15) is provided in the frontal end section, which faces a user, of the cooking plate (7).

5. Arrangement according to one of the preceding claims, **characterised in that** the cooking plate (7) is spaced from the upper side of the work plate (1) with the help of a spacer (19).

## Revendications

1. Dispositif avec une plaque de cuisson dans un logement de plaque de cuisson d'un plan de travail équipée d'une plaque de cuisson en vitrocéramique ou similaire avec des surfaces de contact d'une zone de contact à la face supérieure de la plaque de cuisson, qui sont contrôlées par des capteurs d'une unité de commande de la plaque de cuisson disposés en dessous de la plaque de cuisson, qui communique avec une unité de commande de la plaque de cuisson pour commander des éléments chauffants disposés en dessous de la plaque de cuisson, **caractérisée en ce que** la plaque de cuisson (7) recouvre avec sa zone de commande (15) le plan de travail (1) avec la plaque de cuisson (5) montée dans le logement de plaque de cuisson (3), si bien que celle-ci est disposée sensiblement à l'extérieur du logement de la plaque de cuisson (3).

2. Dispositif selon la revendication 1, **caractérisé en ce que** les capteurs (21) sont disposés entre la plaque de cuisson (7) et le plan de travail (1).

3. Dispositif selon l'une des revendications précédentes, **caractérisé en ce que** la plaque de cuisson (7) recouvre le plan de travail (1) d'environ 10 à 40 mm, en particulier d'environ 15 à 35 mm.

4. Dispositif selon l'une des revendications précédentes, **caractérisé en ce que** la zone de commande (15) est prévue dans la section finale frontale de la plaque de cuisson (7) tournée vers un opérateur.

5. Dispositif selon l'une des revendications précédentes, **caractérisé en ce que** la plaque de cuisson (7) est espacée de la face supérieure du plan de travail (1) à l'aide d'une entretoise (19).
